# FASCICULE DE BREVET EUROPEEN

(11) **EP 4 078 674 B1**
(45) Date de publication et mention de la délivrance du brevet: **15.05.2024**
(21) Numéro de dépôt: 20823860.0
(22) Date de dépôt: 16.12.2020
(51) Int. Cl.: H01L 25/075, H01L 33/56, H01L 33/62, H05K 1/18, H05K 3/28

(54) **ENSEMBLE LUMINEUX POUR DISPOSITIF D'ECLAIRAGE ET/OU DE SIGNALISATION POUR VEHICULE AUTOMOBILE**
LICHTEINHEIT FÜR EINE BELEUCHTUNGS- UND/ODER SIGNALVORRICHTUNG FÜR EIN KRAFTFAHRZEUG
LIGHT UNIT FOR A LIGHTING AND/OR SIGNALLING DEVICE FOR A MOTOR VEHICLE

(30) Priorité: 19.12.2019 FR 1914812
(43) Date de publication de la demande: 26.10.2022
(73) Titulaire: Valeo Vision, 93012 Bobigny Cedex (FR)
(72) Inventeur: ZOJCESKI, Zdravko, 93012 Bobigny Cedex (FR); VAL, Alexandre, 93012 Bobigny Cedex (FR); DAROUSSIN, Samuel, 93012 Bobigny Cedex (FR)
(74) Mandataire: Valeo Visibility
(86) Numéro de dépôt international: PCT/EP2020/086471
(87) Numéro de publication internationale: WO 2021/122781

(56) Documents cités:
- EP-A1- 3 182 470
- EP-A2- 2 760 046
- US-A1- 2009 278 139
- US-A1- 2010 187 547
- US-A1- 2015 133 753
- US-A1- 2019 203 904

## Description

Le domaine de la présente invention est celui des dispositifs d'éclairage et/ou de signalisation pour véhicules automobiles. La présente invention se rapporte plus particulièrement aux dispositifs d'éclairage et/ou de signalisation qui mettent en oeuvre une pluralité de sources lumineuses élémentaires, notamment électroluminescentes.

Les évolutions esthétiques, réglementaires, et l'évolution des contraintes de poids et d'encombrement des différents composants d'un véhicule automobile font qu'il est de plus en plus recherché de réaliser des dispositifs d'éclairage et/ou de signalisation qui présentent de bonnes propriétés optiques avec d'une part une puissance lumineuse et une portée du faisceau émis qui sont appropriées pour éclairer correctement la route ou signaler correctement le véhicule et d'autre part un rendu esthétique pouvant se distinguer de la concurrence, ces dispositifs d'éclairage et/ou de signalisation devant par ailleurs présenter une durée de vie élevée, un faible encombrement et un poids restreint, tout en étant faciles à réaliser.

Dans ce contexte, l'utilisation d'une source émettrice formée d'une pluralité de sources lumineuses élémentaires est de plus en plus répandue, afin de proposer un faisceau pixellisé dans lequel il est possible, pixel par pixel, c'est-à-dire source lumineuse élémentaire par source lumineuse élémentaire, de modifier la forme du faisceau et/ou de modifier globalement ou ponctuellement l'intensité lumineuse du faisceau ou de la zone éclairée qui sert à une fonction de signalisation.

Une problématique à considérer dans la mise en oeuvre de ces faisceaux ou des zones éclairées pixellisés est celle de l'homogénéité lumineuse d'un motif lumineux, telle que perçue par un utilisateur regardant ce motif lumineux. En effet, les sources lumineuses élémentaires formant un tel motif lumineux présentent chacune une forme et un encombrement incompressibles, et leur mise en oeuvre nécessite un écartement minimal entre elles. Un utilisateur regardant le motif lumineux qu'elles forment ensemble peut être amené à voir une forme lumineuse constituée d'un ensemble de points lumineux plus ou moins rapprochés entre eux. Or, il est recherché par les équipementiers et les constructeurs automobiles des dispositifs d'éclairage et/ou de signalisation équipés de sources pixellisées qui permettent toutefois de projeter un faisceau d'apparence homogène.

Une solution, par exemple proposée par le document EP2709185, consiste à mettre en oeuvre des diodes électroluminescentes organiques, également connues sous l'acronyme anglo-saxon OLED (Organic Light Emitting Device), qui permettent de réaliser de véritables surfaces émissives. Outre leur coût, sensiblement plus élevé que celui de diodes électroluminescentes conventionnelles, les diodes électroluminescentes organiques présentent l'inconvénient d'une fiabilité dans le temps inférieure à celle des diodes électroluminescentes classiques. De plus, elles présentent des performances lumineuses sensiblement inférieures à celles des diodes électroluminescentes classiques et elles ne permettent pas d'atteindre les niveaux d'intensité lumineuse du faisceau émis qu'il est possible d'obtenir au moyen de diodes électroluminescentes classiques, également désignées dans ce qui suit par l'acronyme anglo-saxon LED (Light Emitting Device).

US 2019/203904, US 2015/133753, EP 3182470 et US 2010/187547 divulguent chacun un ensemble lumineux comportant une pluralité de sources lumineuses élémentaires agencées sur un support.

L'invention s'inscrit dans ce contexte et vise une alternative aux solutions existantes, afin de proposer un dispositif simple et peu coûteux permettant d'obtenir une surface lumineuse perçue comme homogène par un observateur la regardant.

Dans ce but, l'invention a pour objet un ensemble lumineux pour un dispositif d'éclairage et/ou de signalisation d'un véhicule automobile, comme défini par la revendication 1.

Il convient de noter que les diodes électroluminescentes mises en oeuvre dans l'ensemble lumineux selon l'invention sont des diodes électroluminescentes classiques, ce qui permet de réduire le coût de l'ensemble lumineux selon l'invention, tout en bénéficiant, notamment, d'une puissance lumineuse élevée. Les sources lumineuses élémentaires, formées respectivement par une diode électroluminescente (LED), sont placées sur un support configuré pour réaliser leur alimentation électrique et le pilotage de leur fonctionnement. Pour réaliser l'alimentation électrique des sources lumineuses élémentaires, une première couche conductrice et une deuxième couche conductrice sont agencées de part et d'autre d'une épaisseur du support : une couche conductrice joue le rôle d'anode, l'autre joue le rôle de cathode, et chaque diode électroluminescente, formant source élémentaire, est électriquement reliée à chacune des couches conductrices précitées.

Dans l'ensemble lumineux selon l'invention, chaque source lumineuse élémentaire est insérée dans un orifice agencé dans le support. Il faut donc comprendre ici que le support de l'ensemble lumineux selon l'invention comporte autant d'orifices d'accueil que ce que l'ensemble lumineux selon l'invention comporte de sources lumineuses élémentaires. A titre d'exemple non limitatif de l'invention, une source émettrice pixellisée telle que présente dans l'ensemble lumineux selon l'invention, c'est-à-dire formée par la pluralité de sources lumineuses élémentaires, peut comporter un nombre de sources lumineuses élémentaires pouvant être de l'ordre de plusieurs centaines à plusieurs centaines de milliers. Il est à noter que le support précité peut comporter d'autres orifices, par exemple destinés à recevoir un dispositif de fixation du support dans un boîtier configuré, par exemple, pour loger également un ensemble d'alimentation des sources lumineuses élémentaires et/ou un ensemble électronique de pilotage de ces dernières.

Selon l'invention, chaque orifice d'accueil traverse de part en part la première couche conductrice précitée, ainsi qu'une épaisseur du support, jusqu'à la deuxième couche conductrice. En d'autres termes, chaque orifice d'accueil s'étend sensiblement à travers la totalité d'une épaisseur de la première couche conductrice et à travers la totalité d'une épaisseur du support. Selon un exemple, le support se présente sous la forme d'une plaque sensiblement plane de part et d'autre de l'épaisseur de laquelle sont disposées la première couche conductrice et la deuxième couche conductrice, et chaque orifice d'accueil s'étend sensiblement perpendiculairement au plan principal d'extension de la plaque sensiblement plane précitée.

Il résulte de la configuration des orifices d'accueil que la deuxième couche conductrice, précédemment définie, forme un fond de chacun de ces orifices d'accueil. Selon l'invention, chaque source lumineuse élémentaire est insérée dans un orifice d'accueil de telle manière qu'elle est en contact électrique avec la deuxième couche conductrice précitée. Avantageusement, une dimension de chaque orifice d'accueil est donc supérieure à une dimension correspondante de la source lumineuse élémentaire qu'il reçoit. Il peut notamment être prévu que chaque diode électroluminescente formant une source lumineuse élémentaire présente une partie émissive cylindrique et de section sensiblement circulaire, et l'orifice d'accueil correspondant présente une section circulaire de forme similaire à celle de la section de la source lumineuse élémentaire. On comprend que cette forme de section circulaire n'est pas limitative de l'invention, dès lors que l'orifice d'accueil percé dans le support présente une forme équivalente à celle de la source lumineuse élémentaire qu'il est destiné à recevoir. Selon un exemple, les orifices d'accueil présentent tous la même forme et sont tous sensiblement cylindriques.

Selon l'invention, et tel que cela a été évoqué précédemment, chaque source lumineuse élémentaire est partiellement recouverte d'un matériau optiquement transparent et électriquement conducteur. Plus précisément, le matériau de recouvrement remplit la partie de l'orifice d'accueil de chaque source lumineuse élémentaire inoccupée par cette dernière, en quantité suffisante pour recouvrir cette source lumineuse élémentaire.

Selon une caractéristique de l'invention, on prévoit que, en recouvrant la source lumineuse élémentaire, le matériau de recouvrement optiquement transparent et électriquement conducteur recouvre aussi une partie de la première couche conductrice située au voisinage des bords de l'orifice d'accueil dans lequel la source lumineuse élémentaire considérée est insérée. Ce matériau de recouvrement étant électriquement conducteur, la source lumineuse élémentaire se trouve donc en contact électrique avec la première couche conductrice et partiellement encapsulée dans le matériau de recouvrement précité.

Avantageusement, le matériau de recouvrement est choisi de telle manière qu'il résulte de ses propriétés optiques une forme de diffusion de la lumière émise par chaque source lumineuse élémentaire dans une zone d'émission de dimension plus importante que la zone d'émission de la même source lumineuse élémentaire dans l'air ambiant. L'ensemble lumineux selon l'invention comportant une pluralité de sources lumineuses élémentaires, il en résulte, pour un observateur regardant l'ensemble lumineux émettant un faisceau d'éclairage et/ou de signalisation, un effet de chevauchement des zones d'émission de diodes électroluminescentes voisines et une fusion de ces zones d'émission en une surface lumineuse sensiblement homogène.

L'invention permet ainsi de réaliser, à partir d'une pluralité de sources lumineuses élémentaires, un ensemble lumineux perçu, par un observateur, comme une surface éclairante sensiblement homogène, avec l'utilisation de diodes électroluminescentes, fiables et performantes optiquement à bas coût, fixées de façon simple sur un support commun. L'invention atteint donc bien les différents buts qu'elle s'était fixés.

Selon une caractéristique optionnelle de l'invention, le matériau de recouvrement optiquement transparent et électriquement conducteur forme sensiblement un dôme à la surface du support à partir de laquelle sont agencés les orifices d'accueil des sources lumineuses élémentaires. Une telle forme permet, notamment, de combiner les propriétés de diffusion de la lumière du matériau choisi avec de multiples réfractions de la lumière au sein du dôme précité. Ceci permet d'agrandir la zone d'émission dans laquelle la lumière émise par chaque source lumineuse élémentaire est répartie et, consécutivement, d'augmenter l'homogénéité de la lumière émise au sein de ce volume. Une telle forme contribue donc à renforcer, pour un observateur regardant l'ensemble lumineux selon l'invention, la perception d'une surface éclairante homogène.

Avantageusement, l'invention peut présenter une ou plusieurs des caractéristiques suivantes, prises séparément ou en combinaison :
- chaque source lumineuse élémentaire est fixée sur la deuxième couche conductrice par l'intermédiaire d'un matériau adhésif électriquement conducteur ou par une brasure. Cette brasure ou ce matériau adhésif électriquement conducteur, qui joue ainsi le rôle de colle, permet, d'une part, d'assurer un maintien mécanique de chaque source lumineuse élémentaire avec les parois définissant l'orifice d'accueil, et, d'autre part, de maintenir le contact électrique entre chaque source lumineuse élémentaire et la deuxième couche conductrice formant la paroi de fond de l'orifice d'accueil, afin de permettre l'alimentation électrique des sources lumineuses élémentaires comme précédemment évoqué.
- une dimension d'un orifice d'accueil d'une source lumineuse élémentaire est sensiblement compris entre 100 et 500 micromètres, de préférence entre 100 et 300 micromètres. Un orifice d'accueil présentant une telle dimension est apte à recevoir des diodes électroluminescentes classiques, de construction dite "verticale" de moindre coût.
- un écartement entre deux orifices d'accueil adjacents est compris entre 300 micromètres et 1500 micromètres, de préférence entre 500 et 800 micromètres. On entend ici par "adjacents" deux orifices d'accueil distincts, séparés entre eux uniquement par une partie du support. En d'autres termes, les sources lumineuses élémentaires reçues dans deux orifices d'accueil adjacents sont voisines, et aucune source lumineuse élémentaire n'est intercalée entre elles, sur une ligne droite qui les relie l'une à l'autre sur le support de l'ensemble lumineux selon l'invention. On définit ainsi une forme de "pas" correspondant, par exemple, à un écartement moyen des sources lumineuses élémentaires deux à deux sur le support. En d'autres termes, un tel "pas" représente une distance moyenne entre orifices d'accueil adjacents pris deux à deux sur le support. Selon l'invention, ce "pas" est supérieur ou égal à 300 micromètres. Ceci permet l'utilisation de supports conventionnels, dans lesquels les connexions des différentes diodes électroluminescentes élémentaires peuvent être réalisées avec peu de contraintes d'encombrement, ce qui permet encore de limiter le coût de l'ensemble lumineux selon l'invention. Avantageusement, le "pas" précédemment défini est défini pour permettre, en combinaison avec les dimensions des sources lumineuses élémentaires, d'obtenir un effet visuel de surface éclairante homogène. Ce "pas" est donc suffisamment faible pour permettre la forme de fusion des volumes lumineux émis par les diodes électroluminescentes élémentaires, précédemment évoquée, et suffisamment important pour permettre une réalisation facile et peu coûteuse de l'ensemble lumineux selon l'invention.

- un matériau électriquement isolant est disposé entre la deuxième couche conductrice du support et le matériau de recouvrement optiquement transparent et électriquement conducteur, afin d'éviter tout court-circuit entre la première couche conductrice et la deuxième couche conductrice au travers de la LED élémentaire.
- Selon l'invention, le matériau de recouvrement optiquement transparent et électriquement conducteur est un matériau composite constitué d'un mélange de particules métalliques et d'un matériau plastique. Selon un exemple, un tel matériau composite peut comporter quelques pourcents d'un métal dispersés dans un matériau plastique transparent typiquement résine époxyde ou silicones phénoliques ou méthyliques. Par exemple, un tel matériau composite peut être formé d'une résine de type époxy ou silicone méthylique ou phénolique dans laquelle sont dispersés environ dix pourcents d'un métal, par exemple Ni, Au, Ag, Cu. Il résulte alors de la configuration, précédemment décrite, du recouvrement d'une source lumineuse élémentaire par le matériau précité, que la source lumineuse élémentaire considérée se trouve en contact électrique avec la première couche conductrice, précédemment définie, déposée sur le support. Un matériau isolant est avantageusement inséré, dans l'orifice d'accueil, entre le matériau électriquement conducteur, précédemment défini, au moyen duquel la source lumineuse élémentaire est fixée sur la deuxième couche conductrice, et le matériau de recouvrement tel que décrit ici, au moyen duquel la source lumineuse élémentaire est liée à la première couche conductrice, ce matériau électriquement isolant permettant d'éviter que le courant ne traverse que partiellement une des couches de la diode électroluminescente.

Un autre aspect de l'invention concerne un dispositif d'éclairage pour véhicule automobile comprenant au moins un ensemble lumineux tel qu'évoqué précédemment.

L'invention concerne également un procédé de fabrication d'un ensemble lumineux tel qu'il vient d'être décrit, le procédé étant défini par la revendication 8.

Selon une caractéristique de l'invention, le ou les orifices d'accueil sont réalisés par découpe laser. Un tel procédé de fabrication permet la formation d'orifice d'accueil aux dimensions appropriées, avec une grande précision nécessaire pour recevoir les diodes électroluminescentes et avec une rapidité et une fiabilité d'exécution à moindre coût.

D'autres caractéristiques, détails et avantages de l'invention ressortiront plus clairement à la lecture de la description donnée ci-après à titre indicatif, en relation avec des dessins dans lesquels :
[Fig 1] est une représentation schématique partielle d'un ensemble lumineux selon l'invention, rendant visible une pluralité de diodes électroluminescentes,
[Fig 2] est une vue schématique en coupe d'une diode électroluminescente et d'un détail d'un support d'un ensemble lumineux selon l'invention, selon un premier exemple de réalisation,
[Fig 3] est une vue schématique en coupe d'une diode électroluminescente et d'un détail d'un support d'un ensemble lumineux selon un deuxième exemple, ne faisant pas partie de l'invention.

Il faut tout d'abord noter que si les figures exposent l'invention de manière détaillée pour sa mise en oeuvre, lesdites figures peuvent bien entendu servir à mieux définir l'invention le cas échéant. Il est également à noter que les mêmes éléments sont désignés par les mêmes repères sur l'ensemble des figures.

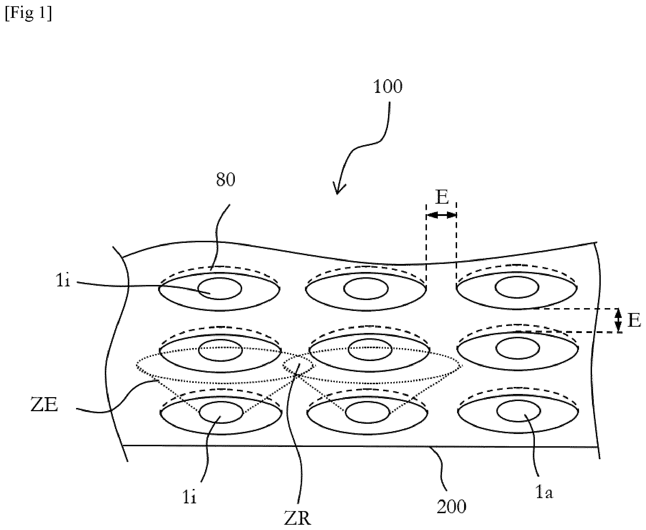

La figure 1 représente schématiquement un ensemble lumineux 100 selon l'invention, susceptible d'équiper un dispositif d'éclairage et/ou de signalisation d'un véhicule automobile. Cet ensemble lumineux comporte un support 200 comprenant une pluralité de sources lumineuses élémentaires 1a, ... 1i, ... 1n, chaque source lumineuse élémentaire étant configurée pour émettre des rayons lumineux en direction d'un élément optique, par exemple une lentille de projection, pour la mise en forme d'un faisceau pixellisé réglementaire d'éclairage et/ou de signalisation, ou bien pour la mise en forme d'une image, ou d'une zone éclairée, pixellisée.

Chaque source lumineuse élémentaire 1i consiste en une diode électroluminescente, également désignée sous l'acronyme anglo-saxon LED. L'ensemble lumineux comporte un module de commande qui pilote une alimentation électrique de chacune de ces diodes électroluminescentes pour les activer ou les éteindre en fonction de la forme à donner au faisceau pixellisé ou à l'image pixellisée. Dans l'exemple illustré, seules deux diodes électroluminescentes 1i sont activées et émettent des rayons lumineux selon une zone d'émission ZE.

Selon l'invention, chaque diode est noyée dans un matériau de recouvrement 80 qui participe à élargir la zone d'émission ZE et qui permet de générer une zone de recouvrement ZR entre deux zones d'émission appartenant respectivement à deux diodes électroluminescentes voisines, malgré l'écartement E nécessaire entre ces deux diodes électroluminescentes voisines.

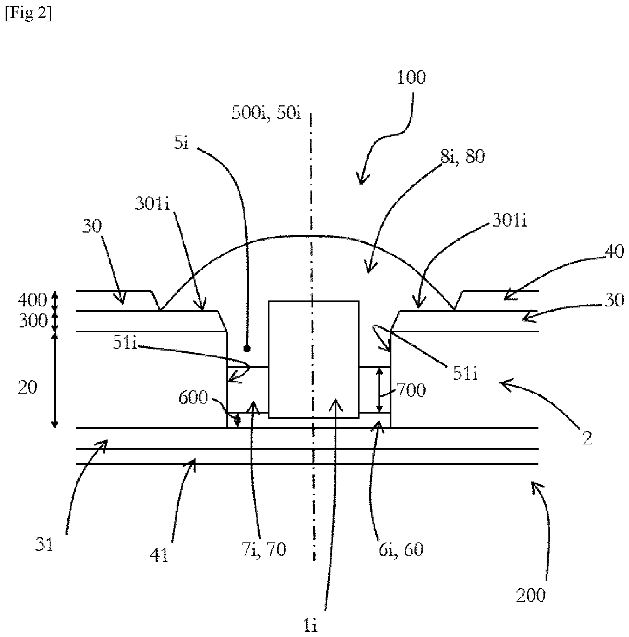

On va maintenant décrire un premier exemple de réalisation de l'invention, en se référant plus particulièrement à la figure 2 qui illustre schématiquement en coupe un détail d'un ensemble lumineux 100, dans la région d'une source lumineuse élémentaire 1i de celui-ci. Le plan de coupe contient un axe d'émission principale de rayons 500i de la source lumineuse élémentaire 1i, et il est sensiblement perpendiculaire à un plan principal d'extension du support 200.

Le support 200 comprend une plaque 2, électriquement isolante, par exemple réalisée dans un matériau plastique typiquement en polyimide (PI) connu comme substrat "FPCB" ou "Flexible PCB", en polycarbonate (PC) qui est utilisé en électronique "imprimé" ou en fibres de glace (connue comme substrat PCB "FR4"). Cette plaque est sensiblement plane et présente une épaisseur, mesurée perpendiculairement au plan principal d'extension du support 2, de part et d'autre de laquelle sont disposées, respectivement, une première couche conductrice 30 et une deuxième couche conductrice 31. Selon un exemple, la première couche conductrice 30 et la deuxième couche conductrice 31 sont réalisées dans le même matériau, par exemple du cuivre ou aluminium. La première couche conductrice 30 et la deuxième couche conductrice 31 sont des couches minces, dont l'épaisseur est faible au regard de l'épaisseur du support 2. Par exemple, l'épaisseur du support 2 est de l'ordre de 100 µm à quelques millimètres, et les épaisseurs de la première et de la première couche conductrice 30 et de la deuxième couche conductrice 31 sont de l'ordre de quelques micromètres à quelques dixièmes de millimètres.

La première couche conductrice 30 est revêtue d'une première couche de protection, électriquement isolante, 40, et la deuxième couche conductrice 31 est revêtue d'une deuxième couche de protection 41, électriquement isolante. Selon un exemple, la première couche de protection 40 et la deuxième couche de protection 41 sont réalisées dans le même matériau plastique, électriquement isolant. Selon un mode de réalisation, la première couche de protection 40 comprend une résine acrylique de couleur blanche ou noire. Selon un autre mode de réalisation, la couleur de la deuxième couche de protection 41 peut être d'une couleur différente de la couleur blanche ou noire, typiquement verte, ce qui permet de réduire un temps d'exposition aux rayons UV lors du processus photolithographique.

Chaque couche conductrice est agencée entre la plaque 2 et la couche de protection qui associée, de sorte que le support 200 comprend donc, perpendiculairement à son plan principal d'extension, l'empilement suivant : première couche de protection 40, première couche conductrice 30, plaque 2, deuxième couche conductrice 31, deuxième couche de protection 41.

L'assemblage du substrat 2 avec les couches conductrices 30 et 31 peut être réalisé sans adhésif, ou avec un adhésif : par exemple, un adhésif acrylique de 50 µm d'épaisseur est disposé entre la deuxième couche conductrice 31 et le substrat 2, et entre la première couche conductrice 30 et le substrat 2.

Selon l'invention, la source lumineuse élémentaire 1i est insérée dans un orifice d'accueil 5i réalisé dans le support 200. Plus précisément, l'orifice d'accueil 5i est réalisé perpendiculairement au plan principal d'extension du support 200 et de sa plaque 2, à partir de la première couche de protection 40 et en direction de la deuxième couche conductrice 31. Plus précisément encore, et en référence à la figure 2, l'orifice d'accueil 5i s'étend successivement à travers la totalité de l'épaisseur 400 de la première couche de protection 40, à travers la totalité de l'épaisseur 300 de la première couche conductrice 30, et à travers la totalité de l'épaisseur 20 de la plaque 2.

L'orifice d'accueil 5i s'étend donc jusqu'à la deuxième couche conductrice 31, sans traverser cette dernière. Celle-ci forme donc un fond de l'orifice d'accueil 5i. Selon le premier exemple de réalisation illustré par la figure 2, l'orifice d'accueil 5i est sensiblement cylindrique, et son axe de révolution 50i est sensiblement perpendiculaire au plan principal d'extension du support 200 et de sa plaque 2.

Il est à noter qu'une dimension de l'orifice d'accueil 5i, dans la région de la première couche de protection 40, est supérieure à la dimension de l'orifice d'accueil 5i dans la région de la première couche conductrice 30 et du support 2. En d'autres termes, la première couche conductrice 30 comporte, autour de la partie de l'orifice d'accueil 5i qui la traverse et qui traverse la plaque 2, une zone périphérique 301i nue et dépourvue de première couche de protection 40.

Chaque orifice d'accueil 5i est notamment formé par une opération de découpe laser, permettant la perforation du support 200 avec précision pour la réalisation d'orifices présentant des dimensions de l'ordre de 300 micromètres, notamment de diamètre lorsque l'orifice d'accueil présente une forme cylindrique de section circulaire. Ces dimensions permettent la réception de diodes électroluminescentes de réalisation standard, dont les dimensions externes sont de l'ordre de 100 à 250 micromètres.

Selon l'invention, chaque source lumineuse élémentaire 1a, ... 1i, ... 1n, est insérée dans un orifice d'accueil 5a, ... 5i, ... 5n, tel que précédemment décrit. Tel qu'illustré, une source lumineuse élémentaire 1i est insérée dans un orifice d'accueil 5i de telle manière que son axe lumineux 500i, précédemment défini, est sensiblement confondu avec l'axe de révolution 50i de l'orifice d'accueil 5i.

La diode électroluminescente 1i est maintenue au fond de l'orifice d'accueil 5i par une couche 6i d'un matériau adhésif électriquement conducteur 60 jouant le rôle de colle, tel que par exemple une colle Ag Époxy ou Ag Silicone, ou une brasure sans plomb, typiquement SnAgCu ou SnCu ou AuSn. Ainsi, la source lumineuse élémentaire 1i est en contact électrique avec la deuxième couche conductrice 31 précédemment définie, la colle conductrice faisant effet de pont conducteur entre la source lumineuse et la deuxième couche conductrice 31 formant le fond de l'orifice d'accueil.

En considérant la direction perpendiculaire au plan principal d'extension du support 200, la diode électroluminescente 1i présente une hauteur sensiblement égale à la profondeur de l'orifice d'accueil de sorte que, chaque couche 6i de matériau adhésif électriquement conducteur 60 présentant une épaisseur 600, la surface libre de la diode électroluminescente fait saillie de la première couche de protection 30.

Une couche 7i d'un matériau électriquement isolant 70 est insérée dans l'orifice d'accueil 5i, dans l'espace situé entre la diode électroluminescente 1i et les parois 51i de l'orifice d'accueil 5i, en venant recouvrir la couche 6i de matériau adhésif électriquement conducteur 60. Cette couche 7i de matériau électriquement isolant 70 présente une épaisseur 700 telle que la surface supérieure, opposée au matériau adhésif électriquement conducteur 60, s'étend sensiblement à mi-hauteur dans l'orifice d'accueil, notamment pour laisser place au matériau de recouvrement 80.

Ce matériau de recouvrement 80 est optiquement transparent et électriquement conducteur et un volume 8i de ce matériau de recouvrement 80 recouvre la partie de la diode électroluminescente 1i émergeant de la couche 7i de matériau électriquement isolant, et notamment la surface libre de la diode électroluminescente 1i. Tel qu'illustré, le matériau de recouvrement 80 recouvre également une partie de la première couche conductrice 30 située autour des bords de l'orifice d'accueil 5i. La surface libre de la diode électroluminescente 1i est ici à entendre comme la surface émissive de cette dernière, visible par un observateur regardant l'ensemble lumineux 100 selon l'invention.

Le matériau de recouvrement 80 forme, selon une direction perpendiculaire au plan principal d'extension du support 200 et de la plaque 2, un dôme au-delà de la diode électroluminescente 1i, à l'opposé de la plaque 2. Par ailleurs, dans un des modes de réalisation, le dôme 8i formé par le matériau de recouvrement 80 s'étend, autour de l'orifice d'accueil 5i, sur la première couche conductrice 30. Plus précisément, le dôme 8i s'étend, selon l'exemple illustré par la figure 2, sur la région 301i, précédemment définie, de la première couche conductrice 30, dépourvue de première couche de protection 40.

Selon le premier exemple de réalisation, illustré par la figure 2, le matériau de recouvrement 80 est un matériau composite constitué, par exemple, de 10% de particules métalliques dispersées dans une résine transparente telle qu'une résine époxy ou silicone phénolique ou méthylique. Le matériau de recouvrement 80 est ainsi d'une part optiquement transparent et d'autre part électriquement conducteur.

Il résulte de ce qui précède que la diode électroluminescente 1i est, d'une part, par l'intermédiaire de la couche 6i de matériau adhésif électriquement conducteur 60, en contact électrique avec la deuxième couche conductrice 31, et, d'autre part, par l'intermédiaire du volume 8i de matériau de recouvrement 80, en contact électrique avec la première couche conductrice 30, la couche 7i de matériau électriquement isolant 70 permettant de s'assurer que le courant délivré spécifiquement pour traverser l'une ou l'autre des couches conductrices traverse uniquement cette couche conductrice. La diode électroluminescente 1i peut ainsi être alimentée électriquement, l'une des couches conductrices 30, 31 jouant le rôle d'anode et l'autre jouant le rôle de cathode.

Par ailleurs, il résulte de la configuration en dôme du volume 8i précédemment défini que la lumière émise par la diode électroluminescente 1i est diffusée de sorte que, telle que cela est visible sur la figure 1, la zone d'émission ZE de chaque diode électroluminescente se chevauche avec la zone d'émission de la diode électroluminescente voisine. Par un choix judicieux de l'écartement E entre deux diodes électroluminescentes voisines 1i, 1j, un observateur regardant l'ensemble lumineux 100 pourra voir des zones d'émission ZE liées les unes aux autres, conduisant à la perception, par cet observateur, d'une surface éclairante homogène. Cette perception d'une surface éclairante homogène peut être accentuée ou atténuée par le choix d'une couleur appropriée de la couche de protection.

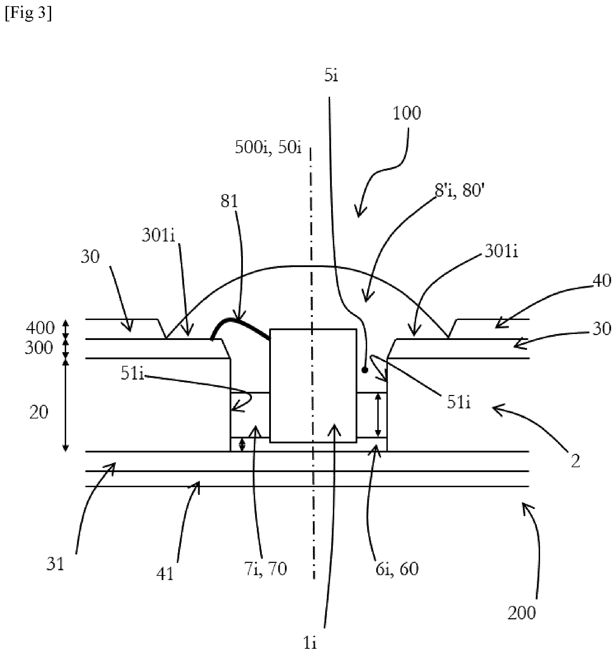

La figure 3 illustre un deuxième exemple, ne faisant pas partie de l'invention, qui se distingue de ce qui a été précédemment décrit par la forme du matériau de recouvrement.

On retrouve sur cette figure la source lumineuse élémentaire 1i formée par une diode électroluminescente 1i, ainsi que le support 200 formé par la plaque 2, la première couche conductrice 30, la deuxième couche conductrice 31, la première couche de protection 40 et la deuxième couche de protection 41 précédemment définies. L'ensemble lumineux selon ce deuxième exemple de réalisation comporte également des orifices d'accueil 5i dans chacun desquels est insérée une diode électroluminescente 1i, une couche 6i de matériau adhésif électriquement conducteur 60, assurant le maintien mécanique de la diode électroluminescente 1i sur la deuxième couche conductrice 31 et le contact électrique avec cette dernière, et une couche 7i de matériau électriquement isolant 70 assurant l'isolation entre la première couche conductrice 30 et la deuxième couche conductrice 31 autour de la diode électroluminescente 1i dans l'orifice d'accueil 5i.

Comme évoqué, l'ensemble lumineux selon ce deuxième exemple diffère de ce qui a été précédemment décrit par la configuration d'un volume 8'i de matériau de recouvrement 80'.

Dans ce deuxième exemple, le matériau de recouvrement 80' est un matériau électriquement isolant dans lequel est placé un fil conducteur 81 destiné à assurer le contact électrique entre la diode électroluminescente 1i et la première couche conductrice 30. Plus précisément, le fil conducteur 81 est avantageusement placé entre la diode électroluminescente 1i et la région 301i, précédemment définie, de la première couche conductrice 30. Une telle variante, si elle implique la réalisation d'une soudure entre la diode électroluminescente 1i et la première couche conductrice 30, permet l'utilisation d'un matériau de recouvrement 80' à bas coût, formé uniquement d'une résine transparente. De manière typique, ce fil conducteur est fait par pointage ("wire bonding" en anglais). Le fil métallique peut être en Aluminium, en Or ou en Cuivre. Le diamètre d'un tel fil est typiquement 25µm ou inférieur.

Dans un autre exemple non représenté, ne faisant pas partie de l'invention, le fil conducteur est remplacé par une grille métallique ("mesh" en anglais). Par exemple, la grille métallique peut être réalisée en aluminium, avec des filaments de 5µm d'épaisseur espacés d'un pas ("pitch" en anglais) de 100µm.

L'invention permet donc bien, par des moyens simples, l'obtention d'un ensemble lumineux offrant à un observateur la perception d'une surface éclairante homogène. Comme indiqué précédemment, l'invention s'étend à un procédé de fabrication d'un tel ensemble lumineux.

Selon une première étape de ce procédé, on réalise une pluralité d'orifices d'accueil 5a, ..., 5i, ... Sn dans le support 200, par une opération de découpe laser. La particularité d'une découpe laser est que le faisceau laser met beaucoup plus de temps à transpercer les couches conductrices 30 et 31 par rapport au temps nécessaire pour transpercer le substrat 2, en particulier lorsque celui-ci est réalisé en polyimide ou en verre-époxy ou polycarbonate PC. De plus, cela garantit que, dans les régions perforées du substrat 2, la deuxième couche conductrice 31 est bien dégagée, de sorte à assurer le contact électrique entre d'une part la deuxième couche conductrice 31 et d'autre part la brasure et/ou le matériau adhésif électriquement conducteur 60 au contact par ailleurs de la diode électroluminescente.

Puis on réalise dans une deuxième étape de mise en place, au fond de chacun des orifices d'accueil 5a, ..., 5i, ... 5n, d'une couche 6a, ... 6i, ... 6n d'un matériau adhésif électriquement conducteur 60.

Une fois l'ensemble des orifices d'accueil réalisé et la colle conductrice ou la brasure sans plomb déposée au fond de ces orifices, les diodes électroluminescentes sont disposées simultanément dans une opération de dépôt massif, avec un support qui les retient toutes et qui est amené en regard du support 200 pour lâcher simultanément les diodes, chacune dans son orifice d'accueil correspondant.

On réalise ensuite la mise en place dans chaque orifice d'accueil d'une couche 7a, ... 7i, ... 7n, d'un matériau électriquement isolant 70, ce matériau électriquement isolant prenant place dans l'orifice d'accueil autour de la diode électroluminescente déjà présente. Tel que cela est illustré sur les figures 2 et 3, la quantité de matériau électriquement isolant 70 est choisie pour que la surface libre de ce matériau s'étende sensiblement à mi-hauteur de l'orifice d'accueil.

La place restant dans chaque orifice d'accueil est ensuite remplie dans une étape de recouvrement par un volume 8a, 8'a, ... 8i, 8'i, ... 8n, 8'n, d'un matériau de recouvrement 80, 80', tel que précédemment décrits.

L'invention telle qu'elle vient d'être décrite ne saurait toutefois se limiter aux moyens et configurations exclusivement décrits et illustrés, et s'applique également à tous moyens ou configurations équivalents et à toute combinaison de tels moyens ou configurations. En particulier, l'invention s'applique quelle que soit la forme des orifices d'accueil, quelle que soit la forme de la LED et quel que soit la forme de la matière transparente recouvrant la LED afin de couvrir des configurations convexes comme présentées sur les figures 1 et 2 aussi bien que des configurations qui ne sont pas représentées, par exemple concaves.

Enfin, l'invention est particulièrement pertinente pour réaliser une source de lumière homogène dont des régions sont électriquement alimentées indépendamment les unes des autres afin d'obtenir une surface homogène. A cet effet, il est possible de découper les couches conductrices 30, 31 du substrat de sorte à obtenir des zones individuellement contrôlables, comportant une ou plusieurs diodes électroluminescentes. Par exemple, ce découpage forme une matrice passive de sources lumineuses telles qu'il en est connu dans l'art. Dans un autre exemple, des composants électroniques sont ajoutés pour réaliser une matrice active de sources lumineuses. Dans un autre exemple, des régions découpées sont indépendamment reliées à des alimentations électriques individuelles. Dans ces exemples, une homogénéité de luminosité de la surface lumineuse peut être améliorée par des alimentations électriques spécifiques aux régions découpées, prenant en compte une mesure de luminosité des régions découpées.

## Revendications

1. Ensemble lumineux (100) pour un dispositif d'éclairage et/ou de signalisation d'un véhicule automobile, comprenant une pluralité de sources lumineuses élémentaires (1a, ... 1i, ... 1n) agencées sur un support (200),
dans lequel chaque source lumineuse élémentaire (1a, ... 1i, ... 1n) est une diode électroluminescente reliée électriquement, d'une part, à une première couche conductrice (30) du support (200) et, d'autre part, à une deuxième couche conductrice (31) du support (200), la première couche conductrice (30) et la deuxième couche conductrice (31) étant agencées de part et d'autre d'une épaisseur (20) du support (200), chaque diode électroluminescente (1a, ... 1i, ... 1n) étant placée dans un orifice d'accueil (5a, ... 5i, ... 5n) agencé dans le support (200), l'orifice d'accueil (5a, ... 5i, ... 5n) s'étendant, respectivement, à travers la première couche conductrice (30) et à travers une épaisseur (20) du support (200) jusqu'à la deuxième couche conductrice (31), chaque diode électroluminescente (1a, ... 1i, ... 1n) étant partiellement encapsulée dans un matériau de recouvrement (80) optiquement transparent et électriquement conducteur, et
le matériau de recouvrement (80) optiquement transparent et électriquement conducteur étant un matériau composite constitué d'un mélange de métal et d'un matériau plastique.

2. Ensemble (100) selon la revendication précédente, **caractérisé en ce que** le matériau de recouvrement (80) optiquement transparent et électriquement conducteur recouvre une partie de la première couche conductrice (30) située au voisinage des bords de l'orifice d'accueil (5a, ... 5i, ... 5n) dans lequel la diode électroluminescente (1a, ... 1i, ... 1n) considérée est insérée.

3. Ensemble (100) selon l'une quelconque des revendications précédentes, **caractérisé en ce que** le matériau de recouvrement (80) optiquement transparent et électriquement conducteur forme sensiblement un dôme (8a, ..., 8i, ...,8n) à la surface du support (200) à partir de laquelle sont agencés les orifices d'accueil (5a, ... 5i, ... 5n) des sources lumineuses élémentaires (1a, ... 1i, ... 1n).

4. Ensemble (100) selon l'une quelconque des revendications précédentes, **caractérisé en ce que** chaque source lumineuse élémentaire (1a, ... 1i, ... 1n) est fixée sur la deuxième couche conductrice (31) par l'intermédiaire d'une brasure ou d'un matériau adhésif électriquement conducteur (60).

5. Ensemble (100) selon l'une quelconque des revendications précédentes, **caractérisé en ce qu'**une dimension d'un orifice d'accueil (5a, ... 5i, ... 5n) d'une source lumineuse élémentaire (1a, ... 1i, ... 1n) est sensiblement compris entre 100 et 500 micromètres.

6. Ensemble (100) selon l'une quelconque des revendications précédentes, **caractérisé en ce qu'**un écartement entre deux orifices d'accueil (5a, ... 5i, ... 5n) adjacents est compris entre 300 micromètres et 1500 micromètres.

7. Ensemble (100) selon l'une quelconque des revendications précédentes, **caractérisé en ce qu'**un matériau électriquement isolant (70) est disposé entre la deuxième couche conductrice (31) du support (200) et le matériau de recouvrement optiquement transparent et électriquement conducteur (80).

8. Procédé de fabrication d'un ensemble lumineux (100) selon l'une quelconque des revendications précédentes, comprenant au moins :
une étape de réalisation, dans un support (200) comportant une première couche conductrice (30) et une deuxième couche conductrice (31) disposées de part et d'autre d'une épaisseur (20) du support (200), d'au moins un orifice d'accueil (5a, ... 5i, ... 5n) traversant la première couche conductrice (30) et l'épaisseur (20) du support (200), jusqu'à la deuxième couche conductrice (31), une dimension de l'orifice d'accueil (5a, ... 5i, ... 5n) étant comprise entre 100 et 500 micromètres,
une étape d'application, au contact de la partie de la deuxième couche conductrice (31) formant le fond de l'orifice d'accueil (5a, ... 5i, ... 5n), d'une brasure ou d'un matériau adhésif électriquement conducteur (60), une étape d'insertion, dans l'orifice d'accueil (5a, ... 5i, ... 5n), d'une diode électroluminescente (1a, ... 1i, ... 1n),
une étape de mise en place, autour de la diode électroluminescente (1a, ... 1i, ... 1n), d'un matériau électriquement isolant (70),
une étape de recouvrement de la diode électroluminescente (1a, ... 1i, ... 1n) par un matériau de recouvrement (80) optiquement transparent et électriquement conducteur, le matériau de recouvrement (80) optiquement transparent et électriquement conducteur étant un matériau composite constitué d'un mélange de métal et d'un matériau plastique.

## Patentansprüche

1. Lichteinheit (100) für eine Beleuchtungs- und/oder Signalvorrichtung eines Kraftfahrzeugs, beinhaltend eine Vielzahl von elementaren Lichtquellen (1a, ... 1i, ... 1n), die auf einem Träger (200) eingerichtet sind, wobei jede elementare Lichtquelle (1a, ... 1i, ... 1n) eine Elektrolumineszenzdiode ist, die einerseits mit einer ersten leitenden Schicht (30) des Trägers (200) und andererseits mit einer zweiten leitenden Schicht (31) des Trägers (200) elektrisch verbunden ist, wobei die erste leitende Schicht (30) und die zweite leitende Schicht (31) zu beiden Seiten einer Dicke (20) des Trägers (200) eingerichtet sind, wobei jede Elektrolumineszenzdiode (1a, ... 1i, ... 1n) in einer in dem Träger (200) eingerichteten Aufnahmeöffnung (5a, ... 5i, ... 5n) platziert ist, wobei sich die Aufnahmeöffnung (5a, ... 5i, ... 5n) jeweils durch die erste leitende Schicht (30) und durch eine Dicke (20) des Trägers (200) bis zu der zweiten leitenden Schicht (31) erstreckt, wobei jede Elektrolumineszenzdiode (1a, ... 1i, ... 1n) teilweise in einem optisch transparenten und elektrisch leitenden Abdeckmaterial (80) verkapselt ist und das optisch transparente und elektrisch leitende Abdeckmaterial (80) ein Verbundmaterial ist, das aus einer Mischung aus Metall und einem Kunststoffmaterial besteht.

2. Einheit (100) nach dem vorhergehenden Anspruch, **dadurch gekennzeichnet, dass** das optisch transparente und elektrisch leitende Abdeckmaterial (80) einen Teil der ersten leitenden Schicht (30) abdeckt, der sich in der Nähe der Ränder der Aufnahmeöffnung (5a, ... 5i, ... 5n), in die die betrachtete Elektrolumineszenzdiode (1a, ... 1i, ... 1n) eingefügt ist, befindet.

3. Einheit (100) nach einem beliebigen der vorhergehenden Ansprüche, **dadurch gekennzeichnet, dass** das optisch transparente und elektrisch leitende Abdeckmaterial (80) an der Oberfläche des Trägers (200), auf der die Aufnahmeöffnungen (5a, ... 5i, ... 5n) der elementaren Lichtquellen (1a, ... 1i, ... 1n) eingerichtet sind, im Wesentlichen eine Kuppel (8a, ..., 8i, ..., 8n) bildet.

4. Einheit (100) nach einem beliebigen der vorhergehenden Ansprüche, **dadurch gekennzeichnet, dass** jede elementare Lichtquelle (1a, ... 1i, ... 1n) mittels einer Lötnaht oder eines elektrisch leitenden Klebematerials (60) an der zweiten leitenden Schicht (31) befestigt ist.

5. Einheit (100) nach einem beliebigen der vorhergehenden Ansprüche, **dadurch gekennzeichnet, dass** ein Maß einer Aufnahmeöffnung (5a, ... 5i, ... 5n) einer elementaren Lichtquelle (1a, ... 1i, ... 1n) im Wesentlichen zwischen 100 und 500 Mikrometer beträgt.

6. Einheit (100) nach einem beliebigen der vorhergehenden Ansprüche, **dadurch gekennzeichnet, dass** ein Abstand zwischen zwei benachbarten Aufnahmeöffnungen (5a, ... 5i, ... 5n) zwischen 300 Mikrometer und 1500 Mikrometer beträgt.

7. Einheit (100) nach einem beliebigen der vorhergehenden Ansprüche, **dadurch gekennzeichnet, dass** zwischen der zweiten leitenden Schicht (31) des Trägers (200) und dem optisch transparenten und elektrisch leitenden Abdeckmaterial (80) ein elektrisch isolierendes Material (70) eingefügt ist.

8. Verfahren zur Fertigung einer Lichteinheit (100) nach einem beliebigen der vorhergehenden Ansprüche, das mindestens Folgendes beinhaltet:
einen Schritt des Herstellens, in einem Träger (200), der eine erste leitende Schicht (30) und eine zweite leitende Schicht (31) umfasst, die zu beiden Seiten einer Dicke (20) des Trägers (200) angeordnet sind, mindestens einer Aufnahmeöffnung (5a, ... 5i, ... 5n), die die erste leitende Schicht (30) und die Dicke (20) des Trägers (200) bis zu der zweiten leitenden Schicht (31) durchquert, wobei ein Maß der Aufnahmeöffnung (5a, ... 5i, ... 5n) zwischen 100 und 500 Mikrometer beträgt,
einen Schritt des Aufbringens, in Kontakt mit dem Teil der zweiten leitenden Schicht (31), der den Boden der Aufnahmeöffnung (5a, ... 5i, ... 5n) bildet, einer Lötnaht oder eines elektrisch leitenden Klebematerials (60),
einen Schritt des Einfügens, in die Aufnahmeöffnung (5a, ... 5i, ... 5n), einer Elektrolumineszenzdiode (1a, ... 1i, ... 1n),
einen Schritt des Einbringens, rund um die Elektrolumineszenzdiode (1a, ... 1i, ... 1n), eines elektrisch isolierenden Materials (70),
einen Schritt des Abdeckens der Elektrolumineszenzdiode (1a, ... 1i, ... 1n) mit einem optisch transparenten und elektrisch leitenden Abdeckmaterial (80), wobei das optisch transparente und elektrisch leitende Abdeckmaterial (80) ein Verbundmaterial ist, das aus einer Mischung aus Metall und einem Kunststoffmaterial besteht.

## Claims

1. Lighting assembly (100) for a lighting and/or signalling device of an automotive vehicle, comprising a plurality of elementary light sources (1a, ... 1i, ... 1n) arranged on a support (200), wherein each elementary light source (1a, ... 1i, ... 1n) is a light-emitting diode electrically connected, on the one hand, to a first conductive layer (30) of the support (200) and, on the other hand, to a second conductive layer (31) of the support (200), the first conductive layer (30) and the second conductive layer (31) being arranged on either side of a thickness (20) of the support (200), each light-emitting diode (1a, ... 1i, ... 1n) being placed in an accommodating orifice (5a, ... 5i, ... 5n) arranged in the support (200), the accommodating orifice (5a, ... 5i, ... 5n) extending, respectively, through the first conductive layer (30) and through a thickness (20) of the support (200) as far as the second conductive layer (31), each light-emitting diode (1a, ... 1i, ... 1n) being partially encapsulated in an optically transparent and electrically conductive covering material (80), and the optically transparent and electrically conductive covering material (80) being a composite material constituted of a mixture of metal and a plastic material.

2. Assembly (100) according to the preceding claim, **characterized in that** the optically transparent and electrically conductive covering material (80) covers a part of the first conductive layer (30) that is situated near the edges of the accommodating orifice (5a, ... 5i, ... 5n) into which the light-emitting diode (1a, ... 1i, ... 1n) in question is inserted.

3. Assembly (100) according to either one of the preceding claims, **characterized in that** the optically transparent and electrically conductive covering material (80) substantially forms a dome (8a,..., 8i, ...,8n) at the surface of the support (200) starting from which are arranged the accommodating orifices (5a, ... 5i, ... 5n) for the elementary light sources (1a, ... 1i, ... 1n),

4. Assembly (100) according to any one of the preceding claims, **characterized in that** each elementary light source (1a, ... 1i, ... 1n) is fastened to the second conductive layer (31) via a solder or an electrically conductive adhesive material (60).

5. Assembly (100) according to any one of the preceding claims, **characterized in that** one dimension of an accommodating orifice (5a, ... 5i, ... 5n) for an elementary light source (1a, ... 1i, ... 1n) is substantially between 100 and 500 micrometres.

6. Assembly (100) according to any one of the preceding claims, **characterized in that** a spacing between two adjacent accommodating orifices (5a, ... 5i, ... 5n) is between 300 micrometres and 1500 micrometres.

7. Assembly (100) according to any one of the preceding claims, **characterized in that** an electrically insulating material (70) is disposed between the second conductive layer (31) of the support (200) and the optically transparent and electrically conductive covering material (80).

8. Method for manufacturing a lighting assembly (100) according to any one of the preceding claims, comprising at least:
a step of making, in a support (200) having a first conductive layer (30) and a second conductive layer (31) that are disposed on either side of a thickness (20) of the support (200), at least one accommodating orifice (5a, ... 5i, ... 5n) passing through the first conductive layer (30) and the thickness (20) of the support (200), as far as the second conductive layer (31), one dimension of the accommodating orifice (5a, ... 5i, ... 5n) being between 100 and 500 micrometres,
a step of applying, in contact with the part of the second conductive layer (31) forming the bottom of the accommodating orifice (5a, ... 5i, ... 5n), a solder or an electrically conductive adhesive material (60),
a step of inserting, into the accommodating orifice (5a, ... 5i, ... 5n), a light-emitting diode (1a, ... 1i, ... 1n),
a step of putting in place, around the light-emitting diode (1a, ... 1i, ... 1n), an electrically insulating material (70),
a step of covering the light-emitting diode (1a, ... 1i, ... 1n) with an optically transparent and electrically conductive covering material (80), the optically transparent and electrically conductive covering material (80) being a composite material constituted of a mixture of metal and a plastic material.
